Europäisches Patentamt

European Patent Office

Office européen des brevets

(19)

(11) **EP 1 494 040 A1**

(12) **EUROPÄISCHE PATENTANMELDUNG**

(43) Veröffentlichungstag:
**05.01.2005 Patentblatt 2005/01**

(51) Int Cl.⁷: **G01R 33/56**, G06T 5/00,
H04N 7/30, H03M 1/08

(21) Anmeldenummer: **03405484.1**

(22) Anmeldetag: **30.06.2003**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(71) Anmelder: **Sulzer Markets and Technology AG
8401 Winterthur (CH)**

(72) Erfinder: **Graf, Hans-Rudolf, Dr.
8400 Winterthur (CH)**

(74) Vertreter: **Sulzer Management AG
Patentabteilung / 0067,
Zürcherstrasse 12
8401 Winterthur (CH)**

(54) **Verfahren zur Kompensation von Quantisierungsrauschen, sowie die Verwendung des Verfahrens**

(57)     Bei dem erfindungsgemässen Verfahren zur Kompensation von Quantisierungsrauschen (1) eines Bilddatensatzes (2) wird der Bilddatensatz (2) aus einem Signal (3) generiert, wobei das Signal (3) in einem Digitalisierer (D) als digitaler Datensatz (4) in einem Signalraum digitalisiert und dadurch mit einem Digitalisierungsrauschen (R) beaufschlagt wird. Der digitale Datensatz (4) wird sodann durch eine ein- oder mehrdimensionale Transformation (T) in ein Bildsignal (5) in einen Bildraum transformiert und danach im Bildraum durch die Anwendung einer Normierungsprozedur (N), durch welche aus dem Bildsignal (5) eine Phaseninformation im wesentlichen eliminiert wird, in den mit dem Quantisierungsrauschen (1) beaufschlagten Bilddatensatz (2) überführt. Dabei werden bei dem erfindungsgemässen Verfahren die Schritte der folgenden Iteration mindestens einmal ausgeführt: mittels eines Schätzverfahrens (6) wird eine Abschätzung (61) für das Quantisierungsrauschen (1) festgelegt. Durch Bildung einer Differenz aus dem Bilddatensatz (2) und der Abschätzung (61) für das Quantisierungsrauschen (1) wird ein Ergebnisdatensatz (7) gebildet, wobei die Schritte der Iteration erneut durchlaufen werden, bis ein vorgebbares Abbruchkriterium (A) für das Quantisierungsrauschen (1 ) erfüllt ist.

Fig.1

**Beschreibung**

Die Erfindung betrifft ein Verfahren zur Kompensation von Quantisierungsrauschen eines Bilddatensatzes in einem Bildraum, sowie die Verwendung des Verfahrens gemäss dem Oberbegriff des unabhängigen Anspruchs der jeweiligen Kategorie.

Beim Digitalisieren von Messsignalen wird das tatsächliche Signal infolge der beschränkten Auflösung des Analog/Digitalwandlers (A/D- Wandler) auf eine ganze Zahl gerundet. Das führt dazu, dass das gemessene analoge Signal in gewisser Weise verfälscht wird und hat nach einer Transformation des Signals im Bildraum den gleichen Effekt, wie wenn zum korrekten Signal ein Rauschanteil addiert wird. Das heisst, das tatsächliche Signal wird durch die Digitalisierung mit einem Digitalisierungsrauschen beaufschlagt.

Häufig ist man in erster Linie jedoch nicht an dem Originalsignal selbst interessiert, sondern das Signal wird als digitalisierter Datensatz aus einem (mathematischen) Signalraum in einen Bilddatensatz zur weiteren Analyse in einen (mathematischen) Bildraum transformiert, wobei die stufenförmige Abtastung des Originalsignals beim Digitalisieren zu einem Digitalisierungsrauschen führt, das sich als Quantisierungsrauschen im Bildraum äussert. Dabei werden in der Literatur die Begriffe "Digitalisierungsrauschen" und "Quantisierungsrauschen" häufig synonym für das Rauschen im Bildraum gebraucht. Zur Unterscheidung wird daher im Rahmen dieser Anmeldung der Begriff Digitalisierungsrauschen für ein Rauschsignal im Signalraum verwendet und der Begriff des Quantisierungsrauschen für das Rauschen im Bildraum verwandt.

Das Digitalisierungsrauschen bzw. das zugehörige Quantisierungsrauschen kann dabei allgemein einer Klasse von Rauschphänomenen zugeordnet werden, die letztlich zu einer Verzerrung eines Signals führen, welche von der Autokorrelationsfunktion (bzw. des Powerspektrums) des Signals abhängen.

Wenn also im Rahmen dieser Anmeldung von "Digitalisierungsrauschen" bzw. von "Quantisierungsrauschen" die Rede ist, ist darunter ganz allgemein jede Art von Verzerrungsrauschen zu verstehen, das zu einer Verzerrung eines Signals führt, wobei die Verzerrungen von der Autokorrelationsfunktion (bzw. vom Powerspektrum des Signals) abhängen und / oder von der Form und / oder Stärke und / oder Frequenzabhängigkeiten mit bestimmt sind. Beispiele hierfür sind unter anderem Verzerrungen, die durch Übersteuern bzw. die nicht-lineare Kennlinie eines Sensors eines, Messverstärkers oder A/D-Wandlers entstehen und / oder durch die Modulation eines Messsignals mit einem Störsignal hervorgerufen werden.

In der Signalanalyse ist für die Praxis die wohlbekannte Fouriertransformation, insbesondere in Form der schnellen Fouriertransformation (Fast Fourier Transform, FFT) von besonders grosser Bedeutung.

Wie allgemein bekannt, lässt sich mit Hilfe der Fouriertransformation beispielsweise aus dem zeitlichen Verlauf eines im Zeitraum (=Signalraum) gemessenen Signals dessen Spektrum im Frequenzraum (=Bildraum) unmittelbar bestimmen, oder auch umgekehrt aus dem gemessenen Spektrum der zeitliche Verlauf eines zugehörigen Signals rekonstruieren.

Dabei wird im Rahmen dieser Anmeldung mit dem Begriff Signalraum jeweils derjenige (mathematische) Ursprungsraum bezeichnet, in welchem das eigentliche Messsignal digitalisiert wird und aus dem in einen, in der Regel (aber nicht notwendig) dazu orthogonalen Zielraum transformiert (also abgebildet) wird, welcher Zielraum im Rahmen dieser Anmeldung allgemein als Bildraum bezeichnet wird und in dem die interessierenden Analysen durchgeführt werden.

Ist man beispielsweise am Frequenzspektrum eines akustischen Signals interessiert, so ist der Signalraum der Zeitbereich, in welchem das akustische Signal mit einem Mikrofon aufgenommen wurde und der Bildraum ist mit dem Frequenzraum gleichzusetzen, in welchem das Schallspektrum analysiert wird. In einem anderen Fall kann der Signalraum jedoch auch mit dem Frequenzraum gleichzusetzen sein. Beispielsweise kann im Rahmen eines CW-Kernresonanzexperiments durch Variation eines angelegten magnetischen Feldes unmittelbar das Frequenzspektrum eines untersuchten Kernspinsystems gemessen werden. In diesem Fall ist der Signalraum im Sinne dieser Anmeldung der Frequenzraum. Zur Untersuchung der Dynamik der makroskopischen Magnetisierung des Kernspinsystems kann das gemessene Spektrum mittels Fouriertransformation in den Zeitraum transformiert werden, wobei in diesem Fall der Zeitraum mit dem Bildraum gleichzusetzen ist.

Selbstverständlich ist die Fourieranalyse nicht nur dazu geeignet zwischen Zeit- und Frequenzraum und umgekehrt zu transformieren. Auch Transformationen zwischen einem Ortsraum und einem Raum der zugehörigen Wellenvektoren ist eine gängige Anwendung, beispielsweise bei der Röntgenspektroskopie oder bei einer Vielzahl anderer Methoden.

Ausserdem ist die Fouriertransformation auch nicht die einzige Transformationsvorschrift die in der Technik vorteilhaft bei der Analyse von Messsignalen einsetzbar ist. Vielmehr existieren eine Vielzahl von Transformationen, die abhängig von der Messmethode oder den zu analysierenden Eigenschaften Verwendung finden. Prominente Beispiele sind die Laplace-Transformation, die Z-Transformation und eine ganze Reihe weiterer allgemeiner Transformationsvorschriften.

Ganz gleich welche Transformation bei welcher Art von Signal zur Analyse eingesetzt wird, tritt, wie bereits erwähnt, das Quantisierungsrauschen immer dann auf, wenn eine im wesentlichen kontinuierliche Grösse, beispielsweise ein analog aufgenommenes Messsignal, in eine Zahl mit endlich vielen Stellen umgesetzt und dann in den Bildraum transformiert wird.

Dies ist zum Beispiel bei der Analog / Digitalwandlung in einem A/D-Wandler grundsätzlich immer der Fall. Die absolute Grösse des Digitalisierungsrauschens hängt dabei von den niederwertigsten bit (Least significant bit, lsb) des Digitalisierers oder allgemeiner von der niederwertigsten Stelle (least significant digit, lsd) der Zahlendarstellung ab. Ist das Digitalisierungsrauschen rein zufällig und statistisch unabhängig, wie beispielsweise bei einem weissen Rauschen, so kann die Rauschamplitude durch wiederholte Messung des Signals und, sofern dies möglich ist, durch wiederholte Mittelwertbildung reduziert werden. Werden n quantisierte Messwerte ermittelt, so kann sich in bestimmten Fällen der zufällige Anteil im Digitalisierungsrauschen proportional zu $1 / \sqrt{n}$ verringern. Der Nachweis der statistischen Unabhängigkeit lässt sich über die Untersuchung der Autokorrelationsfunktion führen, mit deren Hilfe periodische und stochastische Anteile eines Signals getrennt werden können und die im Falle völliger Unabhängigkeit ein nadelförmiger Impuls mit Breite null ist. Zu diesem Impuls gehört im Frequenzraum ein konstantes Leistungsspektrum, das sogenannte weisse Quantisierungsrauschen.

Dabei sind aus dem Stand der Technik verschiedene Methoden zur Unterdrückung oder Kompensation des Digitalisierung- bzw. des Quantisierungsrauschens bekannt, die sowohl im Signalraum, also vor der Transformation, als auch nach der Transformation im Bildraum je nach eingesetztem Verfahren anwendbar sind.

Das sogenannte weisse Rauschen, das unabhängig von der Signalform und dessen Verlauf ist, kann zum Beispiel durch die wohlbekannte Technik des Oversamplings sowohl im Signalraum als auch im Bildraum reduziert werden, so dass de facto die Auflösung eines A/D-Wandlers soweit erhöht werden kann, dass sie besser als ein Quantisierungsschritt ist.

Häufig ist es beispielsweise bei akustischen Signalen so, dass sich das Quantisierungsrauschen vor allem bei hohen Frequenzen auf das Spektrum auswirkt. Durch geeignete Tiefpassfilterung des Messsignals kann dann der Einfluss des Digitalisierungsrauschens und damit die Stärke des Quantisierungsrauschens vermindert werden. Bei genügend tiefer Grenzfrequenz verschwinden dann die Stufen im digitalisierten Signalverlauf weitgehend. Allerdings werden dabei auch die hohen Frequenzanteile des Nutzsignals entsprechend geschwächt oder gar weggefiltert. Das hat zur Folge, dass höherfrequente Signalkomponenten verloren gehen und kaum rekonstruiert werden können.

Dabei werden in der Praxis die Signale durch den Vorgang der Digitalisierung häufig nicht mit einem weissen Rauschen beaufschlagt, das unabhängig von der Frequenz und der Amplitude des interessierenden Signal die gleiche Stärke hat. Vielmehr kann das Rauschen eine Funktion der Frequenz und / oder der Amplitude des Signals sein, so dass das Quantisierungsrauschen im Bildraum, also zum Beispiel im Frequenzspektrum des Signals, nicht überall die gleiche Stärke hat, das heisst, das Quantisierungsrauschen ist abhängig von den Eigenschaften und der Form des Originalsignals.

Auch das Entrauschen von digitalisierten Röntgenbildern, zum Beispiel bei festkörperphysikalischen Strukturuntersuchungen oder in der Medizinaltechnik stellt häufig ein grosses Problem dar. So kann die Stärke des Quantisierungsrauschens nach Transformation eines Röntgenbildes aus dem Wellenvektorraum in den Ortsraum unter anderem vom jeweiligen Grauwert abhängen. Das heisst, dass beispielsweise helle Bereiche stärker verrauscht sein können als dunkle Breiche. Analoge Probleme können bei Methoden wie der Röntgentomographie, der Kernspintomographie, der Analyse insbesondere von chemischen oder biologischen Substanzen mit kernmagnetischer Resonanz oder auch bei der Frequenzanalyse von Ultraschallsignalen usw. auftreten.

Dabei ist es häufig so, dass die Struktur des Quantisierungsrauschens und dessen Auswirkungen auf den durch die Transformation erzeugten Bilddatensatz im Bildraum so komplex ist, dass keine Modelle für das Quantisierungsrauschen zur Verfügung stehen, die es gestatten würden, das Quantisierungsrauschen effizient und korrekt aus dem Bilddatensatz, also beispielsweise aus einem durch Fouriertransformation erstellten Frequenzspektrum eines akustischen Signals zu entfernen. Ausserdem sind die mit Quantisierungsrauschen beaufschlagten Datensätze häufig so gross, dass elektronische Datenverarbeitungsanlage kaum in der Lage wären, aufgrund mehr oder weniger mathematisch exakter Rauschmodelle das Quantisierungsrauschen aus den Bilddaten wieder herauszurechnen.

Daher wird bei den aus dem Stand der Technik bekannten Methoden häufig einfach auf mehr oder weniger geeignete Filtermethoden zurückgegriffen, die jedoch zumindest in bestimmten Bereichen das Signal verfälschen, so dass beispielsweise helle Bereiche eines Röntgenbildes oder hohe Frequenzen eines akustischen Signals stärker unterdrückt oder hervorgehoben werden als andere. Im schlimmsten Fall kann das sogar dazu führen, das beispielsweise schwache Intensitäten im Bildraum vollständig unterdrückt werden.

In speziellen Fällen kann mit Hilfe der Technik des bereits erwähnten "Oversamplings" eine gewisse Verminderung des Quantisierungsrauschen erzielt werden. Allerdings führt diese Technik kaum zum Erfolg, wenn das Quantisierungsrauschen sehr stark von einem weissen Rauschen abweicht und darüber hinaus kann diese Technik auch nicht in jedem Fall angewendet werden.

Die Aufgabe der Erfindung ist es daher, ein verbessertes und vielseitigeres, insbesondere auch ein effizienteres Verfahren zur Kompensation von Quantisierungsrauschen bereitzustellen, sowie die Verwendung des erfindungsgemässen Verfahrens zur verbesserten Analyse von Datensätzen vorzuschlagen, die mit

Die diese Aufgaben in verfahrenstechnischer Hinsicht lösenden Gegenstände der Erfindung sind durch die Merkmale der unabhängigen Ansprüche der jeweiligen Kategorie gekennzeichnet.

Die jeweiligen abhängigen Ansprüche beziehen sich auf besonders vorteilhafte Ausführungsformen der Erfindung.

Bei dem erfindungsgemässen Verfahren zur Kompensation von Quantisierungsrauschen eines Bilddatensatzes wird der Bilddatensatz aus einem Signal generiert, wobei das Signal in einem Digitalisierer als digitaler Datensatz in einem Signalraum digitalisiert und dadurch mit einem Digitalisierungsrauschen beaufschlagt wird. Der digitale Datensatz wird sodann durch eine ein- oder mehrdimensionale Transformation in ein Bildsignal in einen Bildraum transformiert und danach im Bildraum durch die Anwendung einer Normierungsprozedur, durch welche aus dem Bildsignal eine Phaseninformation im wesentlichen eliminiert wird, in den mit den Quantisierungsrauschen beaufschlagten Bilddatensatz überführt. Dabei werden bei dem erfindungsgemässen Verfahren die Schritte der folgenden Iteration mindestens einmal ausgeführt: mittels eines Schätzverfahrens wird eine Abschätzung für das Quantisierungsrauschen festgelegt. Durch Bildung einer Differenz aus dem Bilddatensatz und der Abschätzung für das Quantisierungsrauschen wird ein Ergebnisdatensatz gebildet, wobei die Schritte der Iteration erneut durchlaufen werden, bis ein vorgebbares Abbruchkriterium für das Quantisierungsrauschen erfüllt ist.

Das erfindungsgemässe Verfahren geht somit von einem grundlegend anderen Lösungsansatz aus, als die aus dem Stand der Technik bekannten Verfahren. Bei dem erfindungsgemässen Verfahren wird das Quantisierungsrauschen im Bildraum, also beispielsweise das Quantisierungsrauschen eines Frequenzspektrums eines gemessenen akustischen Signals, geschätzt und vom gemessenen Spektrum subtrahiert. Dabei basiert das Verfahren auf der wohl begründeten Annahme, dass das Spektrum des Quantisierungsrauschens von der Autokorrelation des Eingangssignals, also des gemessenen Signals im Signalraum abhängig ist.

Transformiert in den Bildraum entspricht dies dem sogenannten Autopowerspektrum, wie dem Fachmann wohlbekannt ist. Aus dem zuvor gesagten folgt die für das erfindungsgemässe Verfahren wesentliche Tatsache, dass eine Phaseninformation, die das gemessene Signal trägt, für das Korrekturverfahren nicht notwendig ist.

Im folgenden soll das erfindungsgemässe Verfahren anhand des Beispiels eines akustischen Signals erläutert werden, dass beispielsweise mittels eines hochempfindlichen Mikrofons analog und bevorzugt sehr rauscharm aufgenommen wird, und dann zur Analyse des Frequenzspektrums in einer Datenverarbeitungsanlage bearbeitet werden soll.

Um die Frequenzkomponenten des akustischen Signals in der Datenverarbeitungsanlage auswerten zu können, muss das Signal in einem A/D-Wandler digitalisiert werden. Dadurch erhält der im wesentlichen glatte Verlauf des analogen Signals einen treppenstufenartigen Verlauf, wobei die Höhe der Treppenstufe durch das niederwertigste bit des A/D-Wandlers bestimmt ist. Das digitalisierte Signal wird sodann mittels einer Fouriertransformation, bevorzugt mittels einer schnellen Fouriertransformation (FFT) aus dem Signalraum, hier der Zeitbereich, in den Bildraum, der im konkreten Fall ein Frequenzraum ist, in ein Frequenzspektrum transformiert. Vorteilhaft, jedoch nicht notwendig, finden alle Transformationen auf dem Körper der komplexen Zahlen statt. Durch die Digitalisierung des Signals im Signalraum ist das Frequenzspektrum im Bildraum mit einem Quantisierungsrauschen beaufschlagt. Im weiteren Ablauf wird das Frequenzspektrum in einer Normierungsprozedur normiert und die Phaseninformation des Frequenzspektrums im wesentlichen eliminiert. Das heisst, aus dem Spektrum wird beispielsweise in an sich bekannter Weise das komplexe Betragsquadrats berechnet und das so entstandene Frequenzspektrum, das auch als Powerspektrum dem Fachmann wohl bekannt ist, geeignet normiert. Dabei ist auf eine korrekte Normierung zu achten, da sonst, wie gleich noch beschrieben wird, ein geschätztes Quantisierungsrauschen nicht korrekt aus dem Powerspektrum eliminiert werden kann.

Da das Quantisierungsrauschen, mit dem das Powerspektrum beaufschlagt ist, nicht per se bekannt ist, wird es erfindungsgemäss geschätzt. Zur Abschätzung des Quantisierungsrauschens können je nach Problemstellung verschiedene Schätzverfahren vorteilhaft Verwendung finden, was später noch genauer erläutert werden wird.

In einem einfach gelagerten Fall kann als erste Schätzung zum Beispiel ein weisses Rauschen angenommen werden. In diesem Fall wird das weisse Rauschen in den Bildraum als weisses Quantisierungsrauschen transformiert und kann dann vom Autopowerspektrum des akustischen Signals zum Beispiel subtrahiert werden, wodurch ein Ergebnisdatensatz gebildet wird, der eine verbesserte Schätzung des "wahren", d. h. des unverrauschten Frequenzspektrums darstellt.

Dabei wird beispielsweise der Ergebnisdatensatz, also das zumindest teilweise vom Quantisierungsrauschen befreite Frequenzspektrum, mittels eines Abbruchkriteriums daraufhin untersucht, ob die in den zuvor beschriebenen Schritten erzielte Kompensation des Quantisierungsrauschens ausreichend ist oder nicht. Ist das Abbruchkriterium erfüllt, die erreichte Reduktion des Quantisierungsrauschens also ausreichend, wird der Ergebnisdatensatz, also im vorliegenden Fall das Frequenzspektrum zur weiteren Analyse seiner Eigenschaften übernommen.

Ist das Abbruchkriterium jedoch noch nicht erfüllt, das heisst, die erzielte Reduktion des Quantisierungsrauschens ist noch nicht ausreichend, wird der Ergebnisdatensatz, also das Autopowerspektrum aus dem Frequenzraum mittels einer inversen Transformation, im vorliegenden Fall mittels inverser Fouriertransformation, in den Signalraum zurücktransformiert, und für die Erzeugung einer verbesserten Abschätzung für das Quantisierungsrauschen herangezogen. Diese neue verbesserte Abschätzung für das Quantisierungsrauschen wird dann zur Bildung eines neuen Ergebnisdatensatzes von dem mit Quantisierungsrauschen beaufschlagten Autopowerspektrum, also dem Bilddatensatz subtrahiert, und dass Abbruchkriterium erneut überprüft. Die zuvor beschriebenen Verfahrenschritte, also Erzeugung einer verbesserten Abschätzung für das Quantisierungsrauschen, Bildung eines neuen Ergebnisdatensatzes aus dem Bilddatensatz und Untersuchung des Abbruchkriteriums werden dabei so oft durchlaufen, bis das Abbruchkriterium erfüllt ist, d.h. bis die erreichte Reduktion des Quantisierungsrauschens ausreichend ist. Der Ergebnisdatensatz, also im vorliegenden Fall das Frequenzspektrum wird dann zur weiteren Analyse seiner Eigenschaften übernommen

Das zuvor erwähnte Abbruchkriterium kann dabei, je nach Anwendung, auf unterschiedlichen Kriterien und / oder Verfahren basieren. So kann in einem einfachen Fall nach einer fest vorgebbaren Zahl von Iterationen das Verfahren unabhängig vom Ergebnis abgebrochen werden. Das kann beispielsweise dann sinnvoll sein, wenn aufgrund von Erfahrungswerten davon ausgegangen werden kann, dass nach einer entsprechenden Zahl von Iterationen das Ergebnis automatisch zu einer befriedigenden Reduktion des Quantisierungsrauschens führt. Eine weitere Möglichkeit besteht darin, die Konvergenz der Iteration zu untersuchen. So ist es beispielsweise möglich, das Ergebnis zwei oder mehrerer aufeinanderfolgender Iterationschritte zu vergleichen und wenn konvergentes Verhalten festgestellt wird, das Verfahren abzubrechen. Ein anderes einfaches Abbruchkriterium kann darin bestehen, dass die in einem Iterationsschritt für das Quantisierungsrauschen gefundene Abschätzung in gewisser Weise einen Grenzwert erfüllt, so dass davon auszugehen ist, dass der Ergebnisdatensatz genügend rauschreduziert ist. Selbstverständlich sind die zuvor genannten Beispiele für Abbruchkriterien nur exemplarisch zu verstehen. Jedes in einem speziellen Fall geeignete Abbruchkriterium kann selbstverständlich im speziellen vorteilhaft herangezogen werden.

An dieser Stelle sei noch einmal ausdrücklich darauf hingewiesen, dass, wie bereits eingangs erwähnt, im Rahmen dieser Anmeldung das Quantisierungsrauschen ganz allgemein ein Verzerrungsrauschen, insbesondere ein Verzerrungsrauschen durch Übersteuern und / oder die nicht-lineare Kennlinie eines Sensors eines, Messverstärkers oder A/D-Wandlers und / oder ein Verzerrungsrauschen durch die Modulation eines Messsignals mit einem Störsignal sein kann.

Als sehr einfaches Beispiel für ein Schätzverfahren für eine Abschätzung des Quantisierungsrauschens wurde bereits die einfache Festlegung auf ein weisses Rauschen erwähnt. Im Folgenden soll ein weiteres Verfahren zur Abschätzung des Quantisierungsrauschens beispielhaft erläutert werden, das besonders vorteilhaft dann angewendet werden kann, wenn es sich bei dem zu kompensierenden Quantisierungsrauschen nicht um eine weisses Rauschen handelt, sondern es sich beispielsweise um eine Rauschfunktion handelt, die von der speziellen Form des Signals, der Frequenz und / oder seiner Amplitude abhängt. Dazu kann, wie bereits oben erwähnt, der in den Signalraum zurück transformierte Ergebnisdatensatz vorteilhaft herangezogen werden.

Ein solches Schätzverfahren kann wie folgt realisiert werden: Der Bilddatensatz, also beispielsweise ein mit dem Quantisierungsrauschen beaufschlagtes normiertes Powerspektrum im Frequenzraum wird mit einer vorgebbaren Phasenfunktion zunächst mit einer neuen Phaseninformation beaufschlagt. Da für das erfindungsgemässe Verfahren die Phaseninformation des Signals im wesentlichen keine Auswirkung auf dessen Quantisierungsrauschen des Autopowerspektrums im Frequenzraum hat, kann im Prinzip eine beliebige Phasenfunktion gewählt werden. So kann die Phasenfunktion abhängig von der Frequenz zum Beispiel beliebige Phasen liefern oder die Phasenfunktion kann auch gemäss einer vorgebbaren Funktionschrift jeder Frequenz im Spektrum eine entsprechende Phase zuordnen. Der mit der Phasenfunktion beaufschlagte Bilddatensatz, also zum Beispiel das Autopowerspektrum im Bildraum, wird mittels einer inversen Transformation, beispielsweise einer inversen Fouriertransformation aus dem Bildraum in den Signalraum in ein Modellsignal zurücktransformiert. Das so erhaltene Modellsignal wird im Signalraum erneut digitalisiert, und dadurch mit Digitalisierungsrauschen beaufschlagt in einen digitalen Modelldatensatz überführt. Eine Abschätzung für das Digitalisierungsrauschen erhält man dann durch Bildung einer Differenz aus dem Model/signal und dem digitalisierten Datensatz, wobei dann diese Differenz wieder in den Bildraum, also zum Beispiel in den Frequenzraum transformiert wird, wodurch man ein Quantisierungsrauschen erhält, das man in der oben beschriebenen Iteration des erfindungsgemässen Verfahrens als Abschätzung für das Quantisierungsrauschen verwenden kann.

Das zuvor beschriebene Schätzverfahren kann natürlich auch mit ein und demselben Bilddatensatz parallel mit zwei oder mehreren verschiedenen Phasenfunktionen durchgeführt werden, so dass zwei oder mehr verschiedene Abschätzungen für das Quantisierungsrauschen festlegbar sind, aus welchen dann durch Mittelwertbildung eine neue, noch bessere Abschätzung für das Quantisierungsrauschen festgelegt werden kann.

Selbstverständlich sind die oben beschriebenen Schätzverfahren nur beispielhaft zu verstehen, das heisst im Speziellen können auch andere Schätzverfahren für die Abschätzung des Quantisierungsrauschens, die eventuell einem gegebenen Problem besser angepasst sind, vorteilhaft verwendet werden.

Bei der bisherigen Beschreibung des erfindungsgemässen Verfahrens wurde aus Gründen der Anschaulichkeit als Transformationsvorschrift beispielhaft jeweils die eindimensionale Fouriertransformation und als Signalraum jeweils der Zeitbereich und als Bildraum der Frequenzraum zur Illustration des erfindungsgemässen Verfahrens herangezogen. Es versteht sich, dass das erfindungsgemässe Verfahren darüber hinaus viel allgemeinere Bedeutung hat.

Das heisst, es kann sowohl bei ein- als auch bei mehrdimensionalen Bilddatensätzen das Quantisierungsrauschen erfolgreich kompensiert werden, indem entsprechend höherdimensionale Transformationsvorschriften für die Hin- und Rücktransformation verwendet werden.

Auch kann die Rolle von Signalraum und Bildraum je nach Problemstellung vertauscht sein. Neben dem bereits erwähnten Beispiel aus der kernmagnetischen Resonanz können dafür auch andere Beispiele angegeben werden. So kann es im konkreten Fall möglich sein, dass im Rahmen einer Ultraschallmessung das Frequenzspektrum eines kurzen Ultraschallimpulses von Interesse ist. Dazu wird der Ultraschallimpuls zum Beispiel mit einem Piezoschwinger gemessen, digitalisiert und in einen Frequenzraum transformiert, wobei das Frequenzspektrum vom Quantisierungsrauschen weitgehend zu befreien ist. Der Signalraum ist dann für die Durchführung des erfindungsgemässen Verfahrens der Zeitbereich, der Bildraum ist der Frequenzbereich. In einer anderen Messung kann mittels eines Frequenzanalysators direkt das Frequenzspektrum gemessen werden und aus bestimmten Gründen interessiert der Verlauf der Signalamplitude im Zeitbereich, beispielsweise wenn deren Abklingen als Funktion der Zeit untersucht werden soll. Dann ist der Signalraum zur Durchführung des erfindungsgemässen Verfahrens der Frequenzraum und der Zeitbereich der zugehörige Bildraum.

Darüber hinaus ist das erfindungsgemässe Verfahren auch keineswegs auf Problemstellungen beschränkt, die den Zeitbereich mit dem entsprechenden Frequenzraum verknüpfen. Beispielsweise eignet sich das Verfahren auch hervorragend zur Kompensation von Quantisierungsrauschen bei digitaliserten Röntgenaufnahmen oder anders erstellten Bilddaten, bei denen durch die :Wahl einer geeigneten Transformation bzw. der entsprechenden Rücktransformation ein Ortsraum mit dem zugehörigen Raum der Wellenvektoren verknüpft wird.

Ausserdem ist das erfindungsgemässe Verfahren sowie seine verschiedenen Ausführungsvarianten nicht auf eine bestimmte Klasse von Transformationen beschränkt. Neben der für die Praxis sehr wichtigen ein- oder mehrdimensionalen Fouriertransformation, insbesondere der schnellen Fouriertransformation, können auch andere Transformationen wie beispielsweise die ein- oder mehrdimensionale Laplace-Transformation, die ein- oder mehrdimensionale Z-Transformation oder weitere ein- oder mehrdimensionale Transformationsvorschriften vorteilhaft im Rahmen des erfindungsgemässen Verfahrens eingesetzt werden. Das heisst insbesondere, dass auch bei mehrdimensionalen Bilddatensätzen, wie sie beispielsweise in der Röntgentechnik oder Kernresonanztechnik häufig vorkommen, mit dem hier vorgeschlagenen Verfahren das Quantisierungsrauschen erfolgreich kompensiert werden kann.

Erfindungsgemäss kann somit das Verfahren erfolgreich Verwendung zur Kompensation des Quantisierungsrauschens eines Frequenzspektrums in einem Frequenzraum, insbesondere eines Schallspektrums oder eines Kernresonanzspektrums oder eines Elektronenresonanzspektrums finden.

Eine weitere Verwendung des Verfahrens zur Kompensation des Quantisierungsrauschens ergibt sich bei einer Analyse in einem Ortsraum, insbesondere im Rahmen von Röntgenbeugungsexperimenten.

Weiter kann das erfindungsgemässe Verfahren auch bei einer Analyse in einem Zeitraum, insbesondere bei der Analyse eines Bewegungsablauf im Rahmen von dielektrischen Messungen, elektrischen Messungen oder bei der Analyse eines Zeitverhaltens oder Frequenzverhaltens elektrischer Schaltkreise erfolgreich verwendet werden.

Dabei versteht sich von selbst, dass das Signal, aus dem mittels einer geeigneten Transformation der Bilddatensatz im Bildraum erstellt wird, nicht unbedingt als Messsignal aus einer Messung an einem konkreten physikalischem System vorliegen muss. Selbstverständlich kann das Signal auch künstlich generiert sein, beispielsweise durch eine Datenverarbeitungsanlage und dann digitalisiert werden, beispielsweise um ein Verhalten eines realen physikalischen Systems bei Vorhandensein von Quantisierungsrauschen, z.B. eines elektrischen Schaltkreises, zu untersuchen.

Im Folgenden wird die Erfindung an Hand der schematischen Zeichnung noch näher erläutert. Es zeigen:

Fig. 1      ein Flussdiagramm des erfindungsgemässen Verfahrens;

Fig. 2      ein Flussdiagramm eines Schätzverfahrens zur Abschätzung des Quantisierungsrauschens;

Fig. 3a     ein computergeneriertes Signal mit Digitalisierungsrauschen;

Fig. 3b     Signale gemäss Fig. 3a im Frequenzraum.

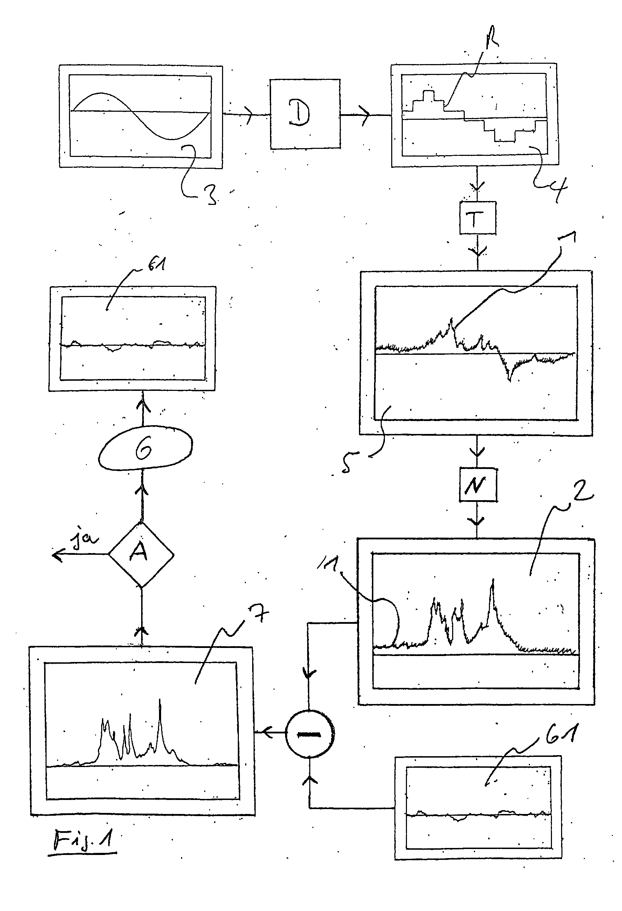

Fig. 1 zeigt in einer schematischen Darstellung ein Flussdiagramm anhand dessen das erfindungsgemässe Verfahren zur Kompensation von Quantisierungsrauschen beispielhaft erläutert wird, wobei das Quantisierungsrauschen im folgenden mit dem Bezugszeichen 1 bezeichnet wird.

Ein Signal 3, das beispielsweise im Rahmen einer Messung oder im speziellen auch beispielsweise durch eine Simulation generiert werden kann, wird in einen Digitalisierer D geladen, der das Signal 3 in einem (mathematischen) Signalraum digitalisiert, wodurch man das digitalisierte Signal in Form des digitalisierten Datensatzes 4 erhält, der mit einem Digitalisierungsrauschen R beaufschlagt ist.

Es versteht sich, das der in Fig. 1 dargestellte Verlauf des Signals 3 als Ausschnitt aus einer Sinusfunktion lediglich exemplarisch zu verstehen ist und der tatsächliche Signalverlauf in der Regel viel komplexer ist. Beispielsweise kann das Signal 3 ein Zeitsignal 3 sein, das im Rahmen einer kernmagnetischen Resonanzmessung (NMR-Messung) an einem Kernspinsystem gewonnen wurde, zum Beispiel im Rahmen einer hochaufgelösten Analyse einer Flüssigkeit zur Untersuchung der chemischen Bestandteile der Flüsssigkeit. Solche Messungen können enorm hoch aufgelöste Signale liefern, insbesondere dann, wenn bei der Messung zusätzliche hochauflösende Techniken wie schnelle Probenrotation (MAS) oder Kreuzpolarisationstechniken zum Einsatz kommen. Solche Analyseverfahren sind in der chemischen Technik, aber auch zur Untersuchung biologischer Substanzen heutzutage weitverbreitet und zur schnellen und exakten Analyse inzwischen von sehr hoher Bedeutung. Gerade weil solche Messungen so hohe Auflösungen erlauben (1/100 Hz bei einer Messfrequenz von 900 MHz sind heute spielend erreichbar), spielt das Quantisierungsrauschen 1 hier eine entscheidende Rolle, weil im Prinzip auch sehr kleine Intensitäten aufgelöst werden können, die jedoch aufgrund des Quantisierungsrauschen 1 im Spektrum verschwinden.

Die hier angesprochene NMR-Messtechnik ist selbstverständlich nur eines von vielen Beispielen, wo das erfindungsgemässe Verfahren besonders vorteilhaft angewendet werden kann. Andere wichtige Beispiele, wie die Analyse akustischer Daten oder die Analyse von röntgenographischen Daten, wurden bereits erwähnt. Auch auf dem Gebiet der optischer Analysen, beispielsweise der Infrarotspektropskie und bei anderen Verfahren ist das erfindungsgemässe Verfahren erfolgreich anwendbar.

Der mit dem Digitalisierungsrauschen beaufschlagte digitale Datensatz 4 wird mittels einer Transformation T aus dem Signalraum in einen Bildraum transformiert. Bevorzugt kommt als Transformation T eine Fouriertransformation T in Frage, wobei selbstverständlich auch andere geeigente Transformationen T je nach Problemstellung vorteilhaft Verwendung finden können. Durch die Transformation T wird der digitale Datensatz 4 in das Bildsignal 5 im Bildraum transformiert. Ist das Signal wie in Fig. 1 beispielhaft dargestellt eine Funktion der Zeit, wie zum Beispiel der freie Induktionsabfall eines NMR-Signals, das heisst der Signalraum ist ein Zeitbereich, und ist die Transformation T eine Fouriertransformation T, speziell eine schnelle Fouriertransformation (FFT), so ist der Bildraum ein Frequenzraum und das Bildsignal 5 ist ein Frequenzspektrum 5 des digitalen Datensatzes 4, wobei das Frequenzspektrum 5 noch eine Phaseninformation des digitalen Datensatzes 4 enthält und durch die Digitalisierung im Zeitbereich mit einem Quantisierungsrauschen 1 beaufschlagt ist. Das Quantisierungsrauschen 1 ist dabei im wesentlichen nicht bekannt, so dass es nicht unmittelbar aus dem Bildsignal 5 eliminierbar ist. Bei dem in Fig. 1 gezeigten Beispiel eines Bildsignals 5 kann es sich unter anderem um ein Spektrum 5 eines NMR-Signals 3 handeln, das beim Digitalisieren mit einem Digitalisierungsrauschen R beaufschlagt wurde.

Auf das Bildsignal 5 wird im folgenden eine Normierungsprozedur N angewendet, wodurch aus dem Bildsignal 5 eine Phaseninformation im wesentlichen eliminiert wird. Die Normierungsprozedur N liefert somit den Bilddatensatz 2, der häufig auch als Powerspektrum 2 oder als Autopowerspektrum 2 bezeichnet wird, wobei das Powerspektrum 2 bezüglich einer Intensität im Spektrum eventuell noch geeignet normiert wird. In dem diskutierten Fall eines NMR-Signals 3 entspricht der Bilddatensatz 2 einem NMR-Powerspektrum 2, das, wie schematisch dargestellt, mit Quantisierungsrauschen 1 beaufschlagt ist, so dass kleine Intensitäten im NMR-Powerspektrum 2 durch das Quantisierungsrauschen 1 eventuell überdeckt werden.

Zur Kompensation des Quantisierungsrauschens 1 wird, eine Abschätzung 61 für das Quantisierungsrauschen 1 festgelegt, wobei die Abschätzung 61 mittels eines Schätzverfahrens 6 gewonnen wird, das an einem konkreten Beispiel später noch im Detail erläutert werden wird. Die Abschätzung 61 für das Quantisierungsrauschen 1 wird sodann durch geeignete Differenzbildung aus dem Bilddatensatz 2 eliminiert, wodurch der Ergebnisdatensatz 7 entsteht, der zum Beispiel weniger stark mit Quantisierungsrauschen beaufschlagt ist, als der Bilddatensatz 2.

Anschliessend wird mittels eines Abbruchkriteriums A untersucht, ob die in den zuvor beschriebenen Schritten erzielte Kompensation des Quantisierungsrauschens 1 ausreichend ist oder nicht. Ist das Abbruchkriterium A erfüllt, die erreichte Reduktion des Quantisierungsrauschens 1 also ausreichend, wird der Ergebnisdatensatz 7, also im vorliegenden Fall das Frequenzspektrum zur weiteren Analyse seiner Eigenschaften übernommen. Ist das Abbruchkriterium A nicht erfüllt, wird eine neue Abschätzung 61 für das Quantisierungsrauschen 1 ermittelt und aus dem Bilddatensatz 2 und der Abschätzung 61 ein neuer Ergebnisdatensatz 7 erstellt.

Das Abbruchkriterium A kann dabei, je nach Anwendung, auf unterschiedlichen Kriterien basieren. So kann in einem einfachen Fall nach einer fest vorgebbaren Zahl von Iterationen das Verfahren unabhängig vom Ergebnis abgebrochen werden. Das kann beispielsweise dann sinnvoll sein, wenn aufgrund von Erfahrungswerten davon ausgegangen werden kann, dass nach einer entsprechenden Zahl von Iterationen das Ergebnis automatisch zu einer befriedigenden Reduktion des Quantisierungsrauschens 1 führt. Eine weitere Möglichkeit besteht darin, die Konvergenz der Iteration zu untersuchen. So ist es beispielsweise möglich, das Ergebnis zwei oder mehrerer aufeinanderfolgender Iterationschritte zu vergleichen und wenn genügend konvergentes Verhalten festgestellt wird, das Verfahren abzubrechen. Ein anderes einfaches Abbruchkriterium A kann darin bestehen, dass die in einem Iterationsschritt für das Quantisierungsrauschen 1 gefundene Abschätzung 61 in gewisser Weise einen Grenzwert erfüllt, so dass davon auszugehen ist, dass der Ergebnisdatensatz 7 genügend rauschreduziert ist.

Andererseits kann es je nach Art des untersuchten Signals 3 vorteilhafter sein, das Abbruchkriterium A anhand eines nach einer Rücktransformation $T^{-1}$ generierten Modelsignals 8 und / oder digitalen Modelldatensatzes 9 zu entscheiden.

Eine weitere Überprüfung des Abbruchkriteriums A kann auch, wie bereits erwähnt, an der Abschätzung 61 für das Quantisierungsrauschens 1 vorgenommen werden. Wenn die Abschätzung 61 ein entsprechendes Abbruchkriterium A erfüllt, wenn beispielsweise eine geeignete gebildete Norm der Abschätzung 61 einen bestimmten vorgebbaren Grenzwert erreicht, kann dies zum Abbruch der Iteration des erfindungsgemässen Verfahrens führen.

Selbstverständlich sind die zuvor genannten Beispiele für Abbruchkriterien A nur exemplarisch zu verstehen. Jedes in einem speziellen Fall geeignete Abbruchkriterium A kann selbstverständlich im speziellen vorteilhaft herangezogen werden. Insbesondere kann in ausgezeichneten Fällen auch eine Kombination von Abbruchkriterien sinnvoll eingesetzt werden.

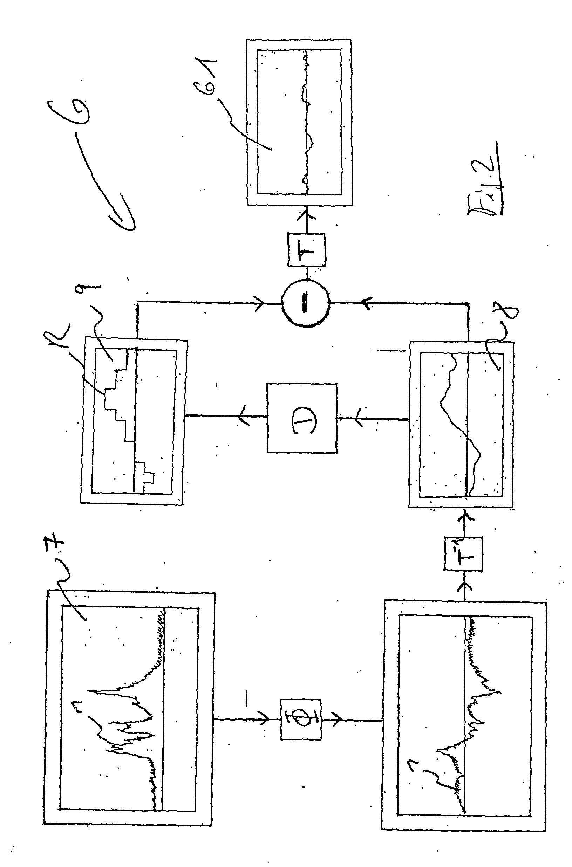

In Fig. 2 ist exemplarisch ein Flussdiagramm eines Schätzverfahrens 6 zur Abschätzung 61 des Quantisierungsrauschens 1 dargestellt, das besonders vorteilhaft dann angewendet werden kann, wenn es sich bei dem zu kompensierenden Quantisierungsrauschen 1 nicht um ein weisses Rauschen handelt, sondern es sich beispielsweise um eine Rauschfunktion handelt, die von der speziellen Form des Signals 3, dessen Frequenz und / oder seiner Amplitude abhängt.

Bei dem in Fig. 2 dargestellten Schätzverfahren 6 wird der Ergebnisdatensatz 7, also beispielsweise ein mit dem Quantisierungsrauschen 1 beaufschlagtes normiertes Powerspektrum 2 im Frequenzraum mit einer vorgebbaren Phasenfunktion Φ zunächst mit einer neuen Phaseninformation beaufschlagt. Da für das erfindungsgemässe Verfahren die Phaseninformation des Signals 3, bzw. die Phaseninformation des digitalen Datensatzes 4 keine Auswirkung auf das Quantisierungsrauschen des Bilddatensatzes 2 im Bildraum hat, kann im Prinzip eine beliebige Phasenfunktion Φ gewählt werden. So kann die Phasenfunktion Φ beispielsweise abhängig von der Frequenz im Frequenzraum beliebige Phasen liefern oder die Phasenfunktion kann auch gemäss einer vorgebbaren Funktionsvorschrift jedem Punkt des Bilddatensatzes 2 im Bildraum eine entsprechende Phase zuordnen. Der mit der Phasenfunktion Φ beaufschlagte Bilddatensatz 2, also zum Beispiel das Autopowerspektrum 2 im Bildraum, wird mittels einer inversen Transformation $T^{-1}$, beispielsweise einer inversen Fouriertransformation $T^{-1}$ aus dem Bildraum in den Signalraum in ein Modellsignal 8 zurücktransformiert. Das so erhaltene Modellsignal 8 wird im Signalraum erneut digitalisiert, und dadurch mit Digitalisierungsrauschen R beaufschlagt und in einen digitalen Modelldatensatz 9 überführt. Eine neue Abschätzung 61 für das Quantisierungsrauschen 1 erhält man dann dadurch, dass eine Differenz aus dem Modellsignal 8 und dem digitalen Modelldatensatz 9 gebildet und diese Differenz wieder in den Bildraum, also zum Beispiel in den Frequenzraum mittels der Transformation T transformiert wird, wodurch man ein Quantisierungsrauschen 1 erhält, das man in der bei Fig. 1 beschriebenen Iteration des erfindungsgemässen Verfahrens als Abschätzung 61 für das Quantisierungsrauschen 1 verwenden kann.

Das zuvor beschriebene und in Fig. 2 dargestellte Schätzverfahren 6 kann natürlich auch mit ein und demselben Bilddatensatz 2 parallel mit zwei oder mehreren verschiedenen Phasenfunktionen Φ durchgeführt werden, so dass zwei oder mehrere verschiedene Abschätzungen 61 für das Quantisierungsrauschen 1 festlegbar sind, aus welchen dann durch Mittelwertbildung eine neue, noch bessere Abschätzung für das Quantisierungsrauschen 1 festgelegt werden kann.

Selbstverständlich ist das in Fig. 2 exemplarisch dargestellte Schätzverfahren 6 nur beispielhaft zu verstehen, das heisst im Speziellen können auch andere Schätzverfahren 6 für die Abschätzung des Quantisierungsrauschens 1, die eventuell einem gegebenen Problem besser angepasst sind, vorteilhaft verwendet werden.

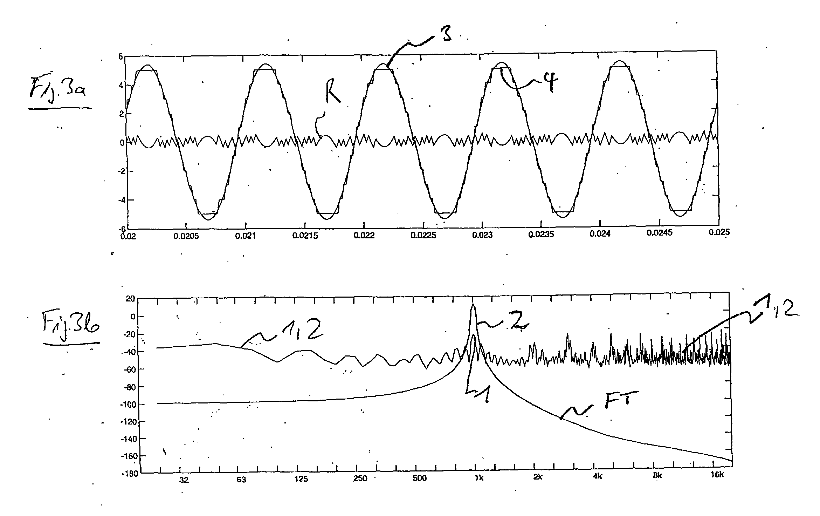

Zur Illustration der Wirkung der Digitalisierung eines Signals 3 und des dadurch erzeugten Digitalisierungsrauschens R im Signalraum bzw. des Quantisierungsrauschens 1 im Bildraum sei auf die Fig. 3a und 3b verwiesen. In Fig. 3a ist als Signal 3 beispielhaft ein Sinussignal 3 mit fester Frequenz und fester Amplitude dargestellt, wie es beispielsweise im Rahmen einer akustischen Messung mittels eines hochempfindlichen rauscharmen Mikrofons mit entsprechender Messeinrichtung aufgenommen werden kann. Auf der Ordinatenachse der Fig. 3a ist dabei die Amplitude, auf der Abszissenachse die Zeit in beliebigen Einheiten aufgetragen. Zur Illustration der Entstehung und der Auswirkung des Digitalisierungsrauschens und dessen Auswirkung auf das Spektrum in Form von Quantisierungsrauschen wurde das in Fig. 3a dargestellte Sinussignal 3 jedoch in einem Rechner simuliert und mathematisch durch eine Treppenfunktion genähert, wodurch der zugehörige digitale Datensatz 4 simuliert wird, wie er durch Digitalisierung des Sinussignals 3 in einem Digitalisierer D erzeugt würde. Da in der in Fig. 3a dargestellten Simulation das Sinussignal 3 und der zugehörige Datensatz 4 bekannt sind, kann das Digitalisierungsrauschen R ausnahmsweise unmittelbar korrekt als Differenz aus dem Signal 3 und dem digitalen Datensatz 4 berechnet werden. Sein zeitlicher Verlauf ist in Fig. 3a ebenfalls durch die Kurve R dargestellt. Wie klar zu erkennen ist, weist das Digitalisierungsrauschen R eine charakteristische Struktur in seinem Zeitverlauf auf, die zumindest im Signalraum, also hier im Zeitbereich keinem weissen Rauschen entspricht.

An dieser Stelle sei ausdrücklich darauf hingewiesen, dass bei einer realen Messung, also wenn das Signal 3 nicht durch eine Simulation generiert wurde, der digitale Datensatz 4 derjenige Datensatz ist, der tatsächlich und einzig als Messsignal zur weiteren Verarbeitung und Analyse, beispielsweise in einer mit der Messeinrichtung in Verbindung stehenden Datenverarbeitungsanlage zur Verfügung steht. Das Signal 3 steht selbstverständlich zur Analyse nicht unmittelbar zur Verfügung, da das gemessene Signal 3 grundsätzlich nur nach vorheriger Digitalisierung im Digitalisierer D zur weiteren Verarbeitung zu Verfügung steht. Das heisst, das Signal 3 ist grundsätzlich unbekannt; bekannt ist lediglich der digitalisierte Datensatz 4, wie er exemplarisch und schematisch in den Figuren dargestellt ist.

Fig. 3b zeigt die simulierten bzw. berechneten Kurven aus Fig. 3a nach einer Transformation in den Bildraum, im vorliegenden Fall in den Frequenzraum. Wie gewöhnlich ist in der Darstellung des Frequenzraums in der Fig. 3b auf der Abszisse die Frequenz in beliebigen Einheiten aufgetragen und auf der Ordinatenachse die Intensität des Autopowerspektrums bei gegebener Frequenz, ebenfalls in beliebigen Einheiten abzulesen. Konkret wurden alle drei Kurven im vorliegenden Beispiel mittels einer Fouriertransformtion aus dem Zeitbereich gemäss Fig. 3a in den Frequenzraum der Fig. 3b transformiert und mittels geeigneter Normierung jeweils das zugehörige Autopowerspektrum berechnet. Die Kurve 2 repräsentiert somit den mit Quantisierungsrauschen 1 beaufschlagten Bilddatensatz 2, die Kurve 61 symbolisiert die Abschätzung 61 für das Quantisierungsrauschen 1, wobei hier die Abschätzung 61 für das Quantisierungsrauschen 1 in der dargestellten Simulation ausnahmsweise sogar korrekt dem tatsächlichen Quantisierungsrauschen entspricht. Ausserhalb des Maximums der Kurve 2 lassen sich die Kurven 1 für reines Quantisierungsrauschen 1 und die Kurve 2 des mit Quantisierungrauschen 1 beaufschlagten Bilddatensatzes 2 praktisch nicht mehr unterscheiden, da in diesen Bereichen der Bilddatensatz 2 vom Quantisierungsrauschen 1 dominiert wird.

Die Kurve FT entspricht der Fouriertransformation des simulierten Sinussignals 3, das selbstverständlich auch ausserhalb von der Mittenfrequenz des in Fig. 3a dargestellten Verlaufs des Sinusignals 3 Frequenzkomponenten aufweist, da das Sinussignal 3 zeitlich begrenzt ist, was auch zu der in Fig. 3b dargestellten Verbreiterung der Kurve FT in der Nähe des Maximums führt. Die scheinbare Asymmetrie der Kurve FT bezüglich des Maximums ist allein durch die logarithmische Darstellung der Frequenzachse in Fig. 3b bedingt.

Eine der wesentlichen Aussagen, die die simulierten Kurven der Fig. 3a und 3b liefern ist, dass selbst sehr einfache Signalformen, wie eine einfache Sinusfunktion, durch Digitalisierung in einem Digitalisierer D mit einem Digitalisierungsrauschen R beaufschlagt werden, das zu einem Quantisierungsrauschen 1 im Bildraum, also z.B. im Frequenzraum führt, das eine deutliche Strukturierung aufweist und somit eben nicht zu einem weissen Quantisierungsrauschen 1 führt. Das zeigt, dass der häufig im Stand der Technik gemachte Ansatz zur Reduktion von Quantisierungsrauschen 1 einfach von einem weissen Modellrauschen auszugehen, das nur ein einziges mal vom Bilddatensatz 2 z.B. im Frequenzraum subtrahiert wird, unweigerlich zu falschen Ergebnissen führen muss. Es versteht sich von selbst, dass solche Fehler um so dramatischer werden, je komplizierter die ursprüngliche Form des gemessenen Signals 3 ist und / oder wenn vor der Transformation T in den Bildraum das Signal 3 beispielsweise noch einer Frequenzfilterung oder anderen Veränderungen unterzogen wird.

Durch Einsatz des erfindungsgemässen Verfahrens werden diese Nachteile vermieden. Falls nicht aus bestimmten Gründen der Typ des Digitalisierungsrauschens und / oder des Quantisierungsrauschens von vorne herein bereits bekannt ist, so dass die Iteration im Rahmen des erfindungsgemässen Verfahrens vorteilhaft mit einem bestimmten vorgebbaren Rauschen, beispielsweise mit einem weissen Rauschen gestartet werden kann, kommt das erfindungsgemässe Verfahren vollkommen ohne ein konkretes Modell für das Quantisierungsrauschen aus. Selbst Signale mit sehr kompliziertem zeitlichen Verlauf und / oder Signale, die vor der Transformation in den Bildraum noch verändert wurden, beispielsweise durch eine Frequenzfilterung, können effizient und korrekt von ihrem Digitalisierungsrauschen befreit werden, ohne das es eines komplizierten mathematischen Modells für das Quantisierungsrauschen bedarf, das ohnehin in der Regel nicht verfügbar ist, und selbst wenn, meist nicht effizient einsetzbar ist.

Nicht zuletzt durch seine einfache Struktur ist das erfindungsgemässe Verfahren sehr universell und effizient einsetzbar, sowohl was die verwendbaren Typen von Transformation bzw. Rücktransformation angeht, als auch was die Methoden der Datenerfassung, also die Messmethoden und die Art der Datensätze und die Dimensionalität der gemessenen Signale und Datensätze angeht.

**Patentansprüche**

1. Verfahren zur Kompensation von Quantisierungsrauschen eines Bilddatensatzes (2), welcher Bilddatensatz (2) aus einem Signal (3) generiert wird, wobei das Signal (3) in einem Digitalisierer (D) als digitaler Datensatz (4) in einem Signalraum digitalisiert und dadurch mit einem Digitalisierungsrauschen (R) beaufschlagt wird, und der digitale Datensatz (4) durch eine ein- oder mehrdimensionale Transformation (T) in ein Bildsignal (5) in einen Bildraum transformiert wird, und danach im Bildraum durch die Anwendung einer Normierungsprozedur (N), durch welche aus dem Bildsignal (5) eine Phaseninformation im wesentlichen eliminiert wird, in den mit dem Quantisierungsrauschen beaufschlagten Bilddatensatz (2) überführt wird, **dadurch gekennzeichnet, dass** bei dem Verfahren die Schritte der folgenden Iteration mindestens einmal ausgeführt werden:

   - mittels eines Schätzverfahrens (6) wird eine Abschätzung (61) für das Quantisierungsrauschen festgelegt und

   - durch Bildung einer Differenz aus dem Bilddatensatz (2) und der Abschätzung (61) für das Quantisierungsrauschen wird ein Ergebnisdatensatz (7) gebildet,

   wobei die Schritte der Iteration erneut durchlaufen werden, bis ein vorgebbares Abbruchkriterium (A) für das Quantisierungsrauschen erfüllt ist.

2. Verfahren nach Anspruch 1, wobei als Abschätzung (61) für das Quantisierungsrauschen ein weisses Rauschen festgelegt wird.

3. Verfahren nach Anspruch 1 oder 2, wobei das Schätzverfahren (6) die folgenden Schritte umfasst:

   - der Ergebnisdatensatz (7) wird im Bildraum mit einer vorgebbaren Phasenfunktion ($\Phi$) mit einer neuen Phaseninformation beaufschlagt,

   - durch eine Rücktransformation ($T^{-1}$) wird der mit der neuen Phaseninformation beaufschlagte Ergebnisdatensatz (7) in den Signalraum in ein Modellsignal (8) zurücktransformiert,

   - das Modellsignal (8) wird im Signalraum digitalisiert, dadurch mit Digitalisierungsrauschen beaufschlagt und in einen digitalen Modelldatensatz (9) überführt,

   - durch Transformation einer Differenz aus dem Modellsignal (8) und dem digitalen Modelldatensatz (9) wird die Abschätzung (61) für das Quantisierungsrauschen im Bildraum festgelegt.

4. Verfahren nach einem der vorangehenden Ansprüche, wobei die Phasenfunktion ($\Phi$) eine Zufallsfunktion ist.

5. Verfahren nach einem der vorangehenden Ansprüche, wobei aus dem Ergebnisdatensatz (7) durch Anwendung von mindestens zwei verschiedenen Phasenfunktionen ($\Phi$) mindestens zwei verschiedene Abschätzungen (61) für das Quantisierungsrauschen festgelegt werden, woraus durch Mittelwertbildung eine neue Abschätzung (61) für das Quantisierungsrauschen festgelegt wird.

6. Verfahren nach einem der vorangehenden Ansprüche, wobei die Transformation (T) und / oder die Rücktransformation ($T^{-1}$) eine ein- oder mehrdimensionale Fouriertransformation, insbesondere eine schnelle Fouriertransformation umfasst.

7. Verfahren nach einem der vorangehenden Ansprüche, wobei die Transformation (T) und / oder die Rücktransformation ($T^{-1}$) eine ein- oder mehrdimensionale Laplacetransformation umfasst.

8. Verfahren nach einem der vorangehenden Ansprüche, wobei das Quantisierungsrauschen ein Verzerrungsrauschen ist, insbesondere ein Verzerrungsrauschen durch Übersteuern und / oder ein Verzerrungsrauschen durch die nicht-lineare Kennlinie eines Sensors, eines Messverstärkers oder eines A/D-Wandlers und / oder ein Verzerrungsrauschen durch die Modulation eines Messsignals mit einem Störsignal.

9. Verwendung eines Verfahrens nach einem der Ansprüche 1 bis 8 zur Kompensation des Quantisierungsrauschens eines Frequenzspektrums (2) in einem Frequenzraum, insbesondere eines Schallspektrums (2) oder eines Kernresonanzspektrums (2) oder eines Infrarotspektrums (2) oder eines Elektronenresonanzspektrums (2).

10. Verwendung des Verfahrens nach einem der Ansprüche 1 bis 8 zur Kompensation des Quantisierungsrauschens bei einer Analyse in einem Ortsraum, insbesondere im Rahmen von Röntgenbeugungsexperimenten.

11. Verwendung des Verfahrens nach einem der Ansprüche 1 bis 8 zur Kompensation des Quantisierungsrauschens bei einer Analyse in einem Zeitraum, insbesondere bei der Analyse eines physikalischen Bewegungsablauf im Rahmen von dielektrischen Messungen, elektrischen Messungen oder bei der Analyse eines Zeitverhaltens elektrischer Schaltkreise.

Fig. 1

Fig. 2

Fig. 3a

Fig. 3b

EP 1 494 040 A1

# EP 1 494 040 A1

**Europäisches Patentamt**

**EUROPÄISCHER RECHERCHENBERICHT**

Nummer der Anmeldung

EP 03 40 5484

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 6 081 552 A (GARDOS THOMAS R ET AL) 27. Juni 2000 (2000-06-27) * Zusammenfassung; Abbildung 3 * * Spalte 4, Zeile 31 - Spalte 5, Zeile 29 * ----- | 1-11 | G01R33/56 G06T5/00 H04N7/30 H03M1/08 |
| A | US 6 438 513 B1 (REYNAUD G EACUTE RARD ET AL) 20. August 2002 (2002-08-20) * Zusammenfassung; Abbildung 1 * ----- | 1-11 | |
| A | BOYCE J M ED - INSTITUTE OF ELECTRICAL AND ELECTRONICS ENGINEERS: "Noise reduction of image sequences using adaptive motion compensated frame averaging" DIGITAL SIGNAL PROCESSING 2, ESTIMATION, VLSI. SAN FRANCISCO, MAR. 23, Bd. VOL. 5 CONF. 17, 23. März 1992 (1992-03-23), Seiten 461-464, XP010058911 ISBN: 0-7803-0532-9 * Seite 461 * ----- | 1-11 | |
| A | EP 0 692 881 A (SONY CORP) 17. Januar 1996 (1996-01-17) * Zusammenfassung * ----- | 1-11 | **RECHERCHIERTE SACHGEBIETE (Int.Cl.7)** H03M G01R H04N G06T |
| E | WO 03/063160 A (GIGI ERCAN F ; KONINKL PHILIPS ELECTRONICS NV (NL)) 31. Juli 2003 (2003-07-31) * Zusammenfassung; Abbildung 1 * ----- | 1-11 | |

Der vorliegende Recherchenbericht wurde für alle Patentansprüche erstellt

| Recherchenort | Abschlußdatum der Recherche | Prüfer |
|---|---|---|
| München | 5. Februar 2004 | Gerdes, R |

**EP 1 494 040 A1**

## ANHANG ZUM EUROPÄISCHEN RECHERCHENBERICHT
## ÜBER DIE EUROPÄISCHE PATENTANMELDUNG NR.

EP 03 40 5484

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-02-2004

| Im Recherchenbericht angeführtes Patentdokument | | Datum der Veröffentlichung | Mitglied(er) der Patentfamilie | | Datum der Veröffentlichung |
|---|---|---|---|---|---|
| US 6081552 | A | 27-06-2000 | KEINE | | |
| US 6438513 | B1 | 20-08-2002 | FR | 2765715 A1 | 08-01-1999 |
| | | | DE | 69806006 D1 | 18-07-2002 |
| | | | DE | 69806006 T2 | 19-12-2002 |
| | | | EP | 0993671 A1 | 19-04-2000 |
| | | | WO | 9901862 A1 | 14-01-1999 |
| | | | JP | 2002513479 T | 08-05-2002 |
| EP 0692881 | A | 17-01-1996 | JP | 3227945 B2 | 12-11-2001 |
| | | | JP | 7135470 A | 23-05-1995 |
| | | | JP | 3227948 B2 | 12-11-2001 |
| | | | JP | 7143009 A | 02-06-1995 |
| | | | EP | 0692881 A1 | 17-01-1996 |
| | | | US | 5774844 A | 30-06-1998 |
| | | | CN | 1117776 A ,B | 28-02-1996 |
| | | | WO | 9513660 A1 | 18-05-1995 |
| WO 03063160 | A | 31-07-2003 | WO | 03063160 A1 | 31-07-2003 |

EPO FORM P0461

Für nähere Einzelheiten zu diesem Anhang : siehe Amtsblatt des Europäischen Patentamts, Nr.12/82